# EUROPÄISCHE PATENTANMELDUNG

(11) **EP 0 533 971 A1**
(43) Veröffentlichungstag der Anmeldung: **31.03.1993**
(21) Anmeldenummer: 91116270.9
(22) Anmeldetag: 24.09.1991
(51) Int. Cl.: H04L 25/08, H03K 17/16

(54) **Schnittstellenschaltung**

(71) Anmelder: SIEMENS AKTIENGESELLSCHAFT, D-80333 München (DE)
(72) Erfinder: Fisch, Alfons, Dipl.-Ing. (FH), W-8411 Falkenstein (DE); Gerken, Hartmut, Dipl.-Ing. (FH), W-8419 Undorf (DE)

(57) **Zusammenfassung**

Über die Schnittstellenschaltung (1) ist ein Steuerbaustein (2) für einen Datenübertragungs-Bus (3) an den Bus angeschlossen. Sie weist zwei durch die Ausgangssignale des Steuerbausteins gesteuerte Treiber (5, 8) auf, die an die Adern des Buses (3) angeschlossen sind. Zwischen den Ausgängen (TX0, TX1) des Steuerbausteins (2) und dem Eingang des jeweiligen Treibers (5, 8) ist je ein Serienwiderstand (R11, R12) eingefügt. Die Ausgänge der Treiber (5, 8) sind über je einen Kondensator (C1, C2) mit Masse verbunden.

## Beschreibung

Die Erfindung betrifft eine Schnittstellenschaltung nach dem Oberbegriff von Anspruch 1.

Eine solche Schnittstellenschaltung dient dazu, einen Steuerbaustein an einen Datenübertragungs-Bus anzuschließen. Der Steuerbaustein steuert die Kommunikation über den Bus. Er ist seinerseits an ein beliebiges Gerät angeschlossen, das die zu übertragenden Daten empfängt und sendet. Solche Geräte sind z.B. in größerer Anzahl in einem Kraftfahrzeug vorhanden. Durch Verbinden dieser Geräte mit dem Bus wird eine Vielzahl von Einzelleitungen eingespart, die herkömmlich für den Datenaustausch zwischen den Geräten erforderlich ist.

Bei einer bekannten Schnittstellenschaltung sind die Ausgänge des Steuerbausteins über je einen Treiber in Form eines Feldeffekttransistors mit den Adern des Buses verbunden (Anwendungsbeispiel des CAN-Controllers 82526 von Intel).

Für manche Anwendungen strahlt die bekannte Schnittstellenschaltung einen zu hohen Störpegel ab. Zum einen wird die Gate-Kapazität der beiden Transistoren durch die beiden Ausgänge des Steuerbausteins sehr schnell umgeladen. Dies führt zu sehr großen Signalflanken-Anstiegsgeschwindigkeiten auf dem Bus und somit zu Störausstrahlungen. Zum anderen entstehen in dem Steuerbaustein selbst aufgrund seiner hohen Taktrate Störspannungen, die durch die Sendeausgänge aus dem Steuerbaustein ausgekoppelt werden und über die Gate-Drain-Kapazitäten der Transistoren auf den Bus übertragen und von diesem abgestrahlt werden. Damit sind aber die an die EMV (elektromagnetische Verträglichkeit) des Bussystems zu stellenden Anforderungen nicht zu erfüllen.

Der Erfindung liegt die Aufgabe zugrunde, eine Schnittstellenschaltung der eingangs genannten Art zu schaffen, mit der die Störausstrahlung des Datenübertragungs-Busses merklich herabgesetzt wird.

Diese Aufgabe wird erfindungsgemäß durch eine Schnittstellenschaltung nach Anspruch 1 gelöst.

Noch stärker wird die Störausstrahlung durch eine Schnittstellenschaltung gemäß Anspruch 2 verringert.

Die Vorteile der Erfindung liegen insbesondere darin, daß nicht nur durch zu große Flankensteilheit auf dem Bus und durch aus dem Steuerbaustein ausgekoppelte Brummfrequenzen verursachte Störabstrahlungen stark herabgesetzt werden, sondern daß auch Störabstrahlungen stark gedämpft werden, oder die von außen, z.B. von in der Nähe verlaufenden Digitalleitungen, verursacht werden.

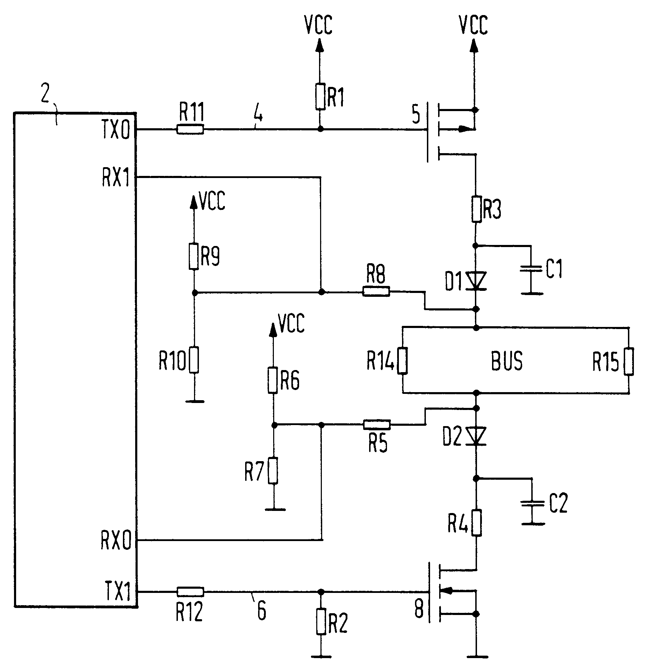

Ein Ausführungsbeispiel der Erfindung wird im folgenden anhand der Zeichnung erläutert.

Die einzige Figur zeigt eine Schnittstellenschaltung gemäß der Erfindung.

Durch eine Schnittstellenschaltung 1 ist ein Steuerbaustein 2 mit einem Datenübertragungs-Bus 3 verbunden. Der Steuerbaustein 2 - z.B. ein sog. CAN-Bus-Controller des erwähnten Typs 82526 - weist zwei Ausgänge oder Sendeports TX0 und TX1 sowie zwei Eingänge oder Empfangsports RX0 und RX1 auf. Der Ausgang TX0 ist durch eine Leitung 4 an das Gate eines Transistors 5 angeschlossen, der als Ausgangstreiber dient. Der Transistor ist z.B. ein p-Kanal MOS-FET des Typs BSS84. Bei den im folgenden genannten Bausteinen handelt es sich auch ohne besondere Erwähnung immer nur um ein mögliches Ausführungsbeispiel. Die Leitung 4 liegt über einen Widerstand R1 von 5k (k = Kilo-Ohm) an der Betriebsspannung VCC von 5 V.

Entsprechend ist der zweite Ausgang TX1 durch eine Leitung 6 an das Gate eines Transistors 8 und über einen Widerstand R2 von 5k an Masse gelegt.

Die Drain des Transistors 5 liegt an VCC, seine Source ist über einen Widerstand R3 von 33 Ohm und eine Diode D1 mit einer Ader des Buses 3 verbunden. Entsprechend ist die Drain des Transistors 6 über einen Widerstand R4 von 33 Ohm und eine Diode D2 mit der anderen Ader des Buses 3 verbunden und seine Source liegt an Masse.

Die vorstehend beschriebenen Schaltungsbestandteile stellen den Sendezweig der Schnittstellenschaltung 1 dar. Beide Transistoren 5, 6 können entweder gleichzeitig durchgeschaltet oder gleichzeitig in nicht leitendem Zustand sein. Im ersteren Fall spricht man von "dominantem" Zustand, im zweiten Fall von "rezessivem" Zustand.

Der Eingang RX0 ist über einen Widerstand R5 von 3k6 (= 3600 Ohm) an die zweite Ader des Buses 3 und an den Verbindungspunkt eines Spannungsteilers angeschlossen, der aus zwei Widerständen R6 von 3k48 und R7 von 4k22 gebildet ist.

Entsprechend ist der Eingang RX1 über einen Widerstand R8 von 3k6 an die erste Ader des Buses 3 und an den Verbindungspunkt eines Spannungsteilers R9 und R10 von je 3k83 angeschlossen. Die beiden Spannungsteiler liegen zwischen VCC und Masse.

Die beschriebenen Widerstandsnetzwerke bilden den Empfangszweig der Schnittstellenschaltung 1. Zwischen den Ausgang TX0 des Steuerbausteins 2 und den Gate-Anschluß des Transistors 5 ist ein Serienwiderstand R11 von 510 Ohm und zwischen dem Ausgang TX1 und dem Gate-Anschluß des Transistors 8 ein Serienwiderstand R12 von 330 Ohm eingefügt. Durch diese beiden Serienwiderstände R11 und R12 wird die Zeitkonstante für die Umladung der Gate-Kapazitäten der Transistoren 5 und 8 vergrößert. Daraus ergibt sich eine kleinere Flankensteilheit der Signale auf dem Bus 3 und somit eine kleinere Störabstrahlung. Die beiden Serienwiderstände R11 und R12 werden in jedem Anwendungsfall so dimensioniert, daß die sich ergebende Flankensteilheit den Anforderungen bei der jeweils auf dem Bus 3 verwendeten Baudrate genügt. Bei Anwendungen in der Kraftfahrzeugtechnik ist der Bus 3 als serieller Bus mit einer programmierten Datenübertragungsrate von bis zu 1 Mbaud ausgebildet. In dem hier beschriebenen Ausführungsbeispiel beträgt die Datenrate etwa 500 Mbaud.

Aus der betrieblichen Praxis ist es bekannt, in die Leitung 4 einen Widerstand einzufügen, der aber nur dazu dient, die durch die unterschiedlichen Transistoren 5 und 8 gestörte Symmetrie der Schnittstellenschaltung wiederherzustellen. Dies wird hier durch die unterschiedlichen Widerstandswerte der Serienwiderstände R11 und R12 erreicht. Die busseitigen Anschlüsse der Widerstände R3 und R4, sind über Kondensatoren C1 bzw. C2 von jeweils 2,2 nF mit Masse verbunden. Die Kondensatoren C1 und C2 bilden zusammen mit dem Serienwiderstand R3 bzw. R4 in der jeweiligen Sendeleitung Tiefpässe, die die Flankensteilheit der Bussignale auf einen definierten Wert begrenzen und die außerdem aus dem Steuerbaustein 2 ausgekoppelten Stör- oder Brummfrequenzen zusätzlich bedämpfen. Ebenso werden von außen eingekoppelte Störsignale zusätzlich bedämpft.

Auch die beiden Serienwiderstände R11 und R12 bilden zusammen mit parasitären Kapazitäten gegen Masse oder gegen die Betriebsspannung - z.B. die Gate-Source-Kapazität der Transistoren 5 und 8 - Tiefpässe, welche die Störauskopplung aus dem Steuerbaustein 2 bedämpfen.

Der Bus 3 weist einen Wellenwiderstand von 120 Ohm auf. Er ist an seinem mit der Schnittstellenschaltung verbundenen "nahen" Ende sowie an seinem "fernen" Ende durch einen Widerstand R14 bzw. R15 von je 120 Ohm abgeschlossen.

Zweckmäßig ist es auch, die Treiber-Transistoren 5 und 8 und weitere der beschriebenen Schaltungsbestandteile in einer integrierten Schaltung zusammenzufassen, die z.B. als integrierter Treiberbaustein realisiert ist.

## Patentansprüche

1. Schnittstellenschaltung (1) zum Anschluß eines Steuerbausteins (2) an einen Datenübertragungs-Bus (3), die zwei von dem Steuerbaustein gesteuerte Treiber (5, 8) aufweist, die an die Adern des Busses angeschlossen sind,
**dadurch gekennzeichnet,**
daß zwischen die Ausgänge (TX0, TX1) des Steuerbausteins (2) und dem Eingang des jeweiligen Treibers (5, 8) je ein Serienwiderstand (R11, R12) eingefügt ist.

2. Schnittstellenschaltung nach Anspruch 1, dadurch gekennzeichnet, daß die an den Bus (3) angeschlossenen Ausgänge (TX0, TX1) der Treiber (5, 8) über je einen Kondensator (C1, C2) mit Masse verbunden sind.

3. Schnittstellenschaltung nach Anspruch 1, dadurch gekennzeichnet, daß sie als integrierter Treiberbautein ausgebildet ist.
